(19) Europäisches Patentamt

European Patent Office

Office européen des brevets

(11) EP 0 942 533 A2

(12) **EUROPEAN PATENT APPLICATION**

(43) Date of publication:
15.09.1999 Bulletin 1999/37

(51) Int. Cl.⁶: **H03K 5/135**

(21) Application number: 99301843.1

(22) Date of filing: 11.03.1999

(84) Designated Contracting States:
AT BE CH CY DE DK ES FI FR GB GR IE IT LI LU
MC NL PT SE
Designated Extension States:
AL LT LV MK RO SI

(30) Priority: 13.03.1998 GB 9805480

(71) Applicants:
• Texas Instruments Limited
Northampton Business Park,
Northampton NN4 7YL (GB)
Designated Contracting States:
GB

• TEXAS INSTRUMENTS INCORPORATED
Dallas Texas 75265 (US)
Designated Contracting States:
DE FR IT NL

(72) Inventors:
• Balmer, Keith
MK40 3BA (GB)
• Robertson, Iain
Bedfordshire, MK44 3TT (GB)

(74) Representative:
Legg, Cyrus James Grahame et al
ABEL & IMRAY,
20 Red Lion Street
London WC1R 4PQ (GB)

(54) **Circuit for Synchronisation**

(57) A circuit for aligning the pulses of an input signal (16) with a clock signal (10) has a divide-by-two counter connected to receive the input signal and a D-type flip-flop (2) connected to latch the output of the divide-by-two counter at times determined by the clock signal. The output of the flip-flop (2) is stabilised by sampling again with another flip-flop (3). The resultant signal is combined using an Exclusive-OR gate (12) with a delayed version of itself, provided by a further flip-flop (4) to produce a signal having a pulse for each pulse in the input signal but at times aligned, or synchronised, with the clock signal.

Fig. 1

## Description

Field Of The Invention

The present invention relates to circuits for synchronising or aligning the pulses of an input signal with those of a clock signal.

Background

The purpose of such a synchronising or aligning is so that logic clocked by the clock signal latches the input signal at times when its level is defined, that is to say away from the edges of the signal. The need for synchronising or aligning occurs where the signal does not have regularly occurring pulses or where the signal is produced by circuitry clocked at a different rate. The latter is often the case when the signal is transmitted over some distance between two apparatuses, and, of course, parts of the same complex circuit may be clocked at different rates.

One approach to this problem is to sample an input signal at points in time determined by a clock signal having a much higher rate than the pulse rate of the input signal. This ensures that each pulse of the input signal is sampled, and hence ensures that information represented as the presence of a pulse in the input signal is not lost.

Summary Of The Invention

This approach is, however, not suitable for use when the clock signal has a similar rate to the rate of the input signal, the problem being that some pulses of the input signal may be missed out from the sampling. As will be seen from the disclosure below, the threshold of the problem is when the input signal contains pulses that are shorter in duration than the period of the clock signal. (Strictly that duration excludes the parts of the pulses so close to the edges of the pulses that the result of their being sampled is indeterminate.)

According to the present invention there is provided a circuit for aligning an input signal with a clock signal comprising:

a terminal for receiving the input signal,
a terminal for receiving the clock signal, pulse length adjustment means for adjusting the length of pulses of the input signal to provide a pulse length adjusted signal, and sampling means for sampling the pulse length adjusted signal at times determined by the clock signal.

The pulse length adjustment means may comprise means for toggling the logic level of the pulse length adjusted signal once for each pulse of a particular type of the input signal, that type of pulse being either a positive pulse or a negative pulse.

The pulse length adjustment means may comprise a divide-by-two counter.

The pulse length adjustment means may comprise a flip-flop.

The sampling means may comprise a flip-flop having a data input connected to receive the pulse length adjusted signal and a clock input connected to receive the clock signal.

The sampling means may comprise a primary sampling means for sampling the pulse length adjusted signal at times determined by the clock signal, and a stabilising means for sampling the output of the primary sampling means at times determined by the clock signal.

The primary sampling means and the stabilising means may be connected to receive the same phase of the clock signal or may be connected to receive different phases of the clock signal.

The circuit may comprise pulse means responsive to an output signal of the sampling means for providing an output signal having a pulse at each edge of the output signal of the sampling means whether that edge is positive- or negative-going.

The pulse means may comprise delay means for providing a delayed version of the output signal of the sampling means, and Exclusive-OR gate means for combining the output signal of the sampling means with the said delayed version of that signal.

The delay means may comprise a flip-flop having a data input connected to receive the output signal of the sampling means.

Any of the flip-flops may be a D-type flip-flop.

According to the present invention there is also provided a circuit comprising:

a terminal for receiving a data signal
means for extracting a clock signal from the data signal
means for generating a local clock signal
pulse length adjustment means for adjusting the length of pulses of the extracted clock signal to provide a pulse length adjusted extracted clock signal,
a first sampling means for sampling the pulse length adjusted extracted clock signal at times determined by the local clock signal to provide an output, and
a second sampling means for sampling the data signal at times determined by the output of the first sampling means.

The present invention may be incorporated into a network switch, or an integrated circuit for use in a network switch.

According to the present invention there is also provided a method of aligning the pulses of an input signal with a clock signal comprising:

adjusting the length of the pulses of the input signal to provide a pulse length adjusted signal having pulses longer than the period of the clock signal, and

sampling the pulse length adjusted signal at times determined by the clock signal.

The pulse length adjustment may comprise toggling the logic level of the pulse length adjusted signal once for each pulse of a particular type of the input signal, that type of pulse being either positive or negative.

The sampling may comprise a sampling of the pulse length adjusted signal at times determined by the clock signal and a sampling of the resultant signal at times determined by the clock signal to stabilise that resultant signal.

The two said samplings may occur at the same phase or at different phases of the clock signal.

The method may comprise forming a signal in response to the signal resulting from the sampling having a pulse at each edge of that signal whether that signal is positive or negative-going.

The said formation of pulses may be performed by Exclusive-OR-ing the signal resulting from the sampling with a delayed version of that signal.

The input signal may be a clock signal extracted from a data signal, and the method of the present invention may also comprise sampling the data signal at times determined by the said aligned input signal.

An embodiment of the invention will now be described by way of example only by reference to the accompanying drawings in which:

Brief Description Of The Drawings

FIGURE 1   is a signal synchronising circuit according to the present invention.

FIGURE 2   is a waveform diagram showing the signals at various points with the circuit of Figure 1 in one use of that circuit.

FIGURE 3   is a variant of the circuit of Figure 1 having means for generating shorter output pulses.

FIGURE 4   is a waveform diagram showing the signals at various points with the circuit of Figure 1 in another use of that circuit.

FIGURE 5   is a block diagram of a network switch making use of a circuit according to the present invention.

FIGURE 6   is a waveform diagram showing the signals at various points in the network switch of Figure 5.

Detailed Description Of The Invention

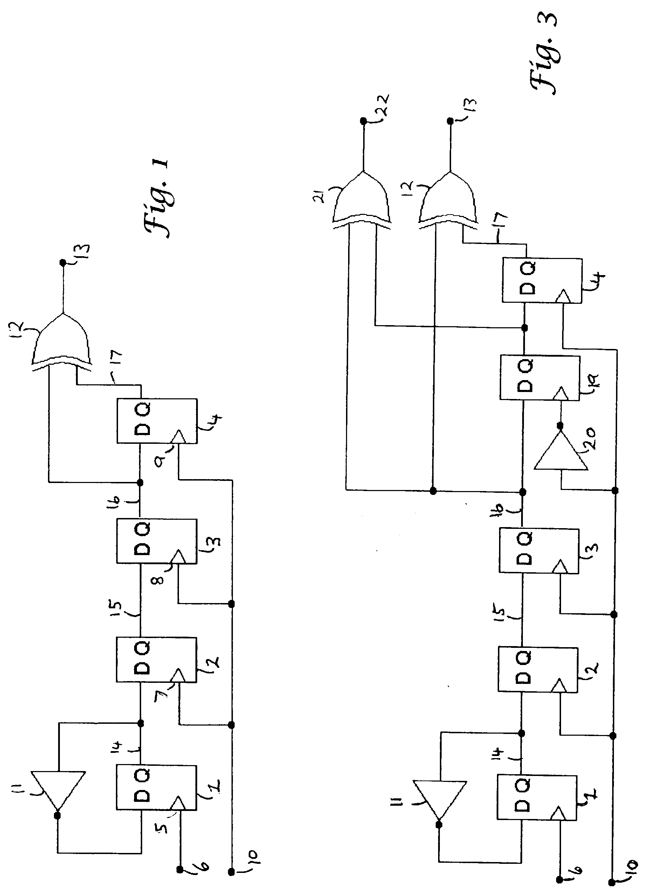

The circuit of Figure 1 comprises four D-type flip-flops 1, 2, 3, 4. (A D-type flip-flop is a circuit which latches the logic level present at its D input when the clock signal applied to its clock input has a positive-going edge and presents that level at its Q output until the next positive-going edge. A D-type flip flop can alternatively be triggered by negative-going edges of the clock signal.)

A clock input 5 of the first flip-flop 1 is connected to receive from an input terminal 6 a signal comprising a succession of pulses, which signal may be a data signal or a clock signal. The clock inputs 7, 8, 9 of the second 2, third 3, and fourth 4, flip-flops are connected to receive a clock signal from an input terminal 10. The four flip-flops are connected in a serial manner, the Q output of each of the first, second, and third, flip-flops being connected to the D input of the next.

The D input of the first flip-flop 1 is connected to receive its own Q output in an inverted form provided by an inverter 11.

An Exclusive-OR gate 12 is connected to receive as its two inputs the Q outputs of the third 3 and fourth 4 flip-flops and has an output connected to an output terminal 13.

Some examples of how the circuit of Figure 1 may be used are set out below together with an explanation of the operation of the circuit.

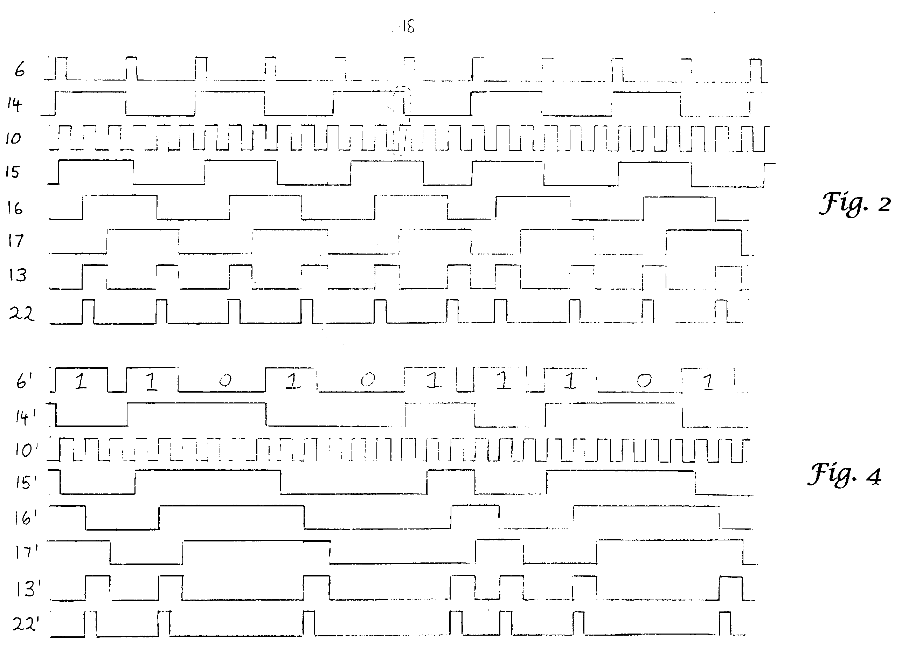

The circuit of Figure 1 may be used to align the pulses of a clock signal with a clock signal of a higher frequency. Figure 2 shows the signals present in such a case on the terminals 6, 10, 13 and also on the conductors 14, 15, 16, 17 connected to the Q outputs of the flip-flops. The signals have been labelled with the same reference numerals as the conductors and terminals on which they occur.

The clock signal input to the circuit on terminal 6 has, in this example, a low duty cycle of about 15%. The first D-type flip-flop 1 is clocked by this signal and its output Q on conductor 14 toggles at each positive-going edge of the input signal 6 because the inverter 11 presents at the D input of the flip-flop 1 the inverted value of the Q output of flip-flop 1. The first flip-flop 1 and the inverter therefore act as a divide-by-two circuit and it is to be noted that the output of the first flip-flop is a regular pulse train with a 50% duty cycle and half the frequency of the signal input to the circuit at terminal 6.

Some constructions of D-type flip-flop automatically provide both an output of the latched value Q and that level inverted $\overline{Q}$. In such a case a separate inverter 11 is not required. The inverted output $\overline{Q}$ of the flip-flop may be fed back to its D input.

The second flip-flop 2 latches, at each positive-going edge of the clock signal input to the circuit at terminal 10, the level of the Q output on conductor 14 of the first flip-flop 1. The effect of that is, comparing the output of the second flip-flop 2 to that of the first 1, that each edge of the signal 14 is delayed until the occurrence of the next edge of the clock signal 10. The output of the second flip-flop 2 is, as may be seen from the waveform 15 in Figure 2, no longer of constant period. It does, however, have an edge for each pulse in the signal input on terminal 6.

The advantage of the transformation of the input signal effected by the first flip-flop 1 and inverter 11 may now be seen. In Figure 2 the period of the clock signal 10 is about twice the duration of the positive pulses of the input signal 6, and several of those pulses do not have within their duration a positive-going edge of the clock signal 10. Therefore, if the input signal 6 were sampled directly at times determined by the positive-going edges of the clock signal 10, then those pulses would not be sampled and information would be lost. The divide-by-two counter formed by the first flip-flop 1 and the inverter 11 produces, however, a signal 14 with equally long alternate positive and negative pulses for each positive pulse of the input signal 6 respectively, and the duration of the pulses of the signal 14 is equal in length to the period of the input signal 6, much longer than the 15% pulses of the input signal 6. These pulses of the signal 14 are long enough to ensure that they are all sampled by the second flip-flop 2, in the present case two or three times each.

The input signal 6 is a clock signal, so the information that it carries is a series of ticks and these are represented as a pulse once every period of the clock. In the output signal 14 of the first flip-flop 1 that information is preserved as a series of edges at the same frequency. In the output 15 of the second flip-flop 2 those edges are preserved one for one but they are re-timed so that they occur aligned with edges of the clock signal 10.

It will also be seen that because the pulse length in the output of the first flip-flop 1 is the full duration of the period of the input signal 6 then the circuit will operate to produce an edge in the output signal 15 of the second flip-flop for each pulse of the input signal 6 as long as the frequency of the clock signal 10 is greater than or almost equal to that of the input signal 6.

The third flip-flop 3 latches the output 15 of the second flip-flop 2 at each positive-going edge of the clock signal input at terminal 6. That delays the signal 15 by one period of the clock signal 10. The purpose of the third latch 3 is to suppress glitches that could occur in subsequent circuitry as a result of the output of the second latch 2 being meta-stable when it samples the output of the first latch near an edge in that signal. An example of such a point is marked 18 in Figure 2. The third flip-flop 3 allows the output of the second to settle before it samples it. The output of the third flip-flop is therefore always stable at the times normally expected for a D-type flip-flop. The third flip-flop may be arranged to be triggered from another phase of the clock signal 10, for example, by connecting an inverter between the terminal 10 and the clock input 8 of the third flip-flop 3. This reduces the propagation delay of the circuit of Figure 1 but reduces the time allowed for the output of the second flip-flop 2 to settle before its output is sampled by the third 3.

The fourth flip-flop 4 introduces another delay of one period of the clock signal input at terminal 10. The output of this flip-flop is then Exclusive-OR-ed with the output of the third 3, which has the effect of converting all the edges, both positive and negative, in the output of the third flip flop to positive pulses. This reverses the pulse to edge transformation provided by the first flip-flop 1.

The overall effect of the circuit of Figure 1 is then to convert the pulse train input at terminal 6 to a pulse train output at terminal 13 having the same average pulse rate but with the pulses occurring at positive-going edges of the clock signal 10. One use for the circuit is therefore in data transmission where data is clocked into a first-in-first-out (FIFO) buffer at times determined by the input clock signal 6. The data may be then read out from the buffer, at the same average rate, at times determined by the output 13 of the circuit of Figure 1 into circuits clocked by the clock signal 10.

If it is desired to have separate return to zero pulses in the output 13 of the circuit if Figure 1, then the particular form of the stage of the circuit implemented by the fourth flip-flop 4 and the Exclusive-OR gate 12 limits the useful range of operation of the circuit of Figure 1 to the case where the clock signal 10 has twice the frequency of the input signal 6. If the clock signal 10 is slower than that then there will be times for which the signal output by Exclusive-OR gate 13 is high during two consecutive periods of clock signal 10. This limitation may be remedied by providing a suitable pulse generating circuit which produces a pulse shorter than one period of the clock signal 10. If however a non-return to zero signal is acceptable to the circuits connected to the output 13 then this limit does not apply.

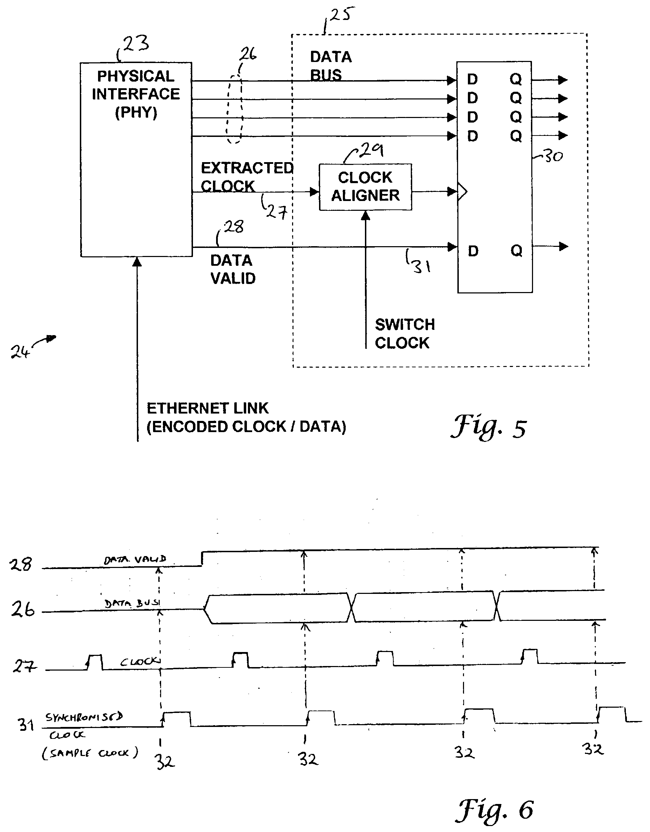

Figure 3 illustrates a modified form of the circuit of Figure 1 in which means for providing shorter output pulses has been provided in addition to the fourth flip-flop 4 and the Exclusive-OR gate 12 which provide pulses equal in length to one period of the clock signal 10. A fifth flip-flop 19 has been inserted between the third 3 and the fourth 4 and is connected to receive at its D input the Q output of the third flip-flop 3 and to provide its Q output to the D input of the fourth flip-flop 4. The clock input of the fifth flip-flop 19 is, however, connected to an inverted form of the clock signal 10 provided by an inverter 20. A further Exclusive-OR gate 21 is also provided and is connected to receive as its inputs the Q outputs of the third flip-flop 3 and the additional fifth flip-flop 19. Because the third flip-flop is clocked by the clock signal 10 and the fifth flip-flop is clocked by that signal inverted the waveform output by the fifth flip-flop 19 is the same as that output by the third flip-flop 3 but delayed by half a period of the clock signal 10. (A delay of a different fraction of the clock signal would result if the duty cycle of the clock signal was other than 50%.) The output of the further Exclusive-OR gate 21 is connected to an output terminal 22 and the signal on that terminal has therefore a pulse equal in length to half the period of the clock signal 10 for each pulse in the input signal 6. That output waveform is shown in Figure 2 at 22. The fourth flip-flop 4 produces exactly the same waveform as before with the same timing with respect to the input signals because it now delays the waveform output by the additional fifth flip-flop one further half period of the clock signal 10. Therefore the waveform at terminal 13 output by the Exclusive-OR gate 12 is exactly the same as before.

In the example given above of the use of the circuit of Figure 1 the signal input to terminal 6 is a clock signal. As shown in Figure 4 the waveform could also be a return to zero data waveform 6' consisting, for example, of a pulse to represent a logic "1" and the absence of a pulse to represent a "0". In this case the circuit again operates to produce an output 13' having a pulse for each pulse of the input waveform 6', the output pulses being aligned with the clock signal 10'.

The presence of "0"s in the output may be inferred from the number of cycles of the clock signal 10' for which there is no pulse in the output signal 13' or, if the data signal has an associated clock signal, by treating that clock signal in a similar manner to the data signal and comparing the outputs. For example, if the clock signal 6 of Figure 2 were a clock signal associated with the data waveform of 6' of Figure 3 both could be passed through respective Figure 1 circuits and then "0"s in the output 13' for the data waveform could be inferred by comparison with the output signal 13 for the clock signal.

Also illustrated in Figure 4 is the output waveform 22' that would be produced on terminal 22 in the variation of the circuit shown in Figure 3 if supplied with the return to zero waveform 6'.

As an alternative to the divide-by-two counter provided by the first flip-flop 1 and the inverter 11, a pulse generation or stretching circuit may be used, followed by a sampling stage as before. The pulse generation or stretching circuit is used, in one example, to reform the input signal so that it has an about 50% duty cycle to ensure that there are no short pulses, either positive or negative, that escape the subsequent sampling process. An advantage of this arrangement is that the final stage of converting edges back to pulses is not required.

In comparison the divide-by-two arrangement of Figure 1 has the advantage that it provides a 50% duty cycle waveform automatically without *a priori* knowledge of the frequency and of the pulse length of the input signal. Further, as explained above the circuit of Figure 1, with the modification disclosed, can produce separate pulses with the clock signal having a frequency of down to that of the input signal. (The corresponding limit for a circuit where the divide-by-two counter is replaced by a pulse generating or stretching circuit is that the clock signal should have a frequency of at least twice the reciprocal of the length of pulse produced, assuming a 50% duty cycle is produced. That is because to reproduce pulses it is necessary in such an example to sample both during a pulse and then again during the subsequent period at the other logic level.)

Pulse generation circuits or monostables are well known. A pulse stretching circuit may comprise a delay circuit (unclocked) producing a single output or several outputs delayed by different amounts and OR-ing the delayed signals together, usually together with the undelayed signal. This works for active high pulses; AND-ing the delayed pulses is required for active-low pulses.

The signal input to the circuit at terminal 6 need not have a regular timing but could have pulses produced at random, for example, by some physical process being sensed by a transducer. In this case subsequent pulses would only be resolved if they were separated by at least the period of the clock signal.

The variations in the construction of the circuit of Figure 1 disclosed above may also be made in the case of all the uses of the circuit disclosed above.

One use of the invention is in a network switch, such as are used in Ethernet local area networks and other networks.

In one example of that, shown in Figure 5, a physical interface integrated circuit 23 of a network switch 24 receives a signal from an Ethernet network and demodulates it to retrieve a digital baseband data signal. The data is formed into four bit words for transmission to a switch integrated circuit 25 over a data bus 26. The switch integrated circuit routes the packets received to other physical interface circuits for transmission on to their destinations. A clock signal and a data valid signal are extracted and are transmitted to the switch integrated circuit 25 by the physical interface circuit 23 on conductors 27 and 28 respectively. These signals are asynchronous with the local clock signal used to operate the main parts of the switch. The switch uses a circuit 29 according to the present invention to re-time the pulses of the extracted clock signal 31, which may have narrow pulses, so that they are aligned with pulses of the local clock signal. The delay in a clock pulse is not such that the corresponding data pulse has come to an end, i.e. the data is still valid. Therefore the data signal on bus 26 is sampled directly by a multiple bit D-type flip-flop 30 at times determined by the aligned clock signal pulses 31, there being no need to re-time the data signal. The D-type flip-flop 30 is also used to sample the data valid signal. Signals on the various conductors of the circuit of Figure 5 are shown in Figure 6 and are labelled with corresponding numerals. The times at which the flip-flop 30 latches the data and data valid waveforms are marked by vertical dashed lines 32 in Figure 6.

**Claims**

1. A circuit for aligning an input signal with a clock signal comprising:

   a terminal for receiving the input signal,
   a terminal for receiving the clock signal,
   pulse length adjustment means for adjusting the length of pulses of the input signal to provide a pulse length adjusted signal, and sampling means for sampling the pulse length adjusted signal at times determined by the clock signal.

2. A circuit as claimed in claim 1, wherein the pulse length adjustment means comprises means for toggling the logic level of the pulse length adjusted signal once for each pulse of a particular type of the input signal, that type of pulse being either a positive pulse or a negative pulse.

3. A circuit as claimed in claim 2, wherein the pulse length adjustment means comprises a divide-by-two counter.

4. A circuit as claimed in any preceding claim, wherein the sampling means comprises:

   a flip-flop having a data input connected to receive the pulse length adjusted signal and a clock input connected to receive the clock signal.

5. A circuit as claimed in any preceding claim, wherein the sampling means comprises:

   a primary sampling means for sampling the pulse length adjusted signal at times determined by the clock signal, and
   a stabilising means for sampling the output of the primary sampling means at times determined by the clock signal.

6. A circuit as claimed in claim 5, wherein the primary sampling means and the stabilising means are connected to receive the same phase of the clock signal.

7. A circuit as claimed in claim 5, wherein the primary sampling means and the stabilising means are connected to receive different phases of the clock signal.

8. A circuit as claimed in any preceding claim comprising:

   pulse means responsive to an output signal of the sampling means for providing an output signal having a pulse at each edge of the output signal of the sampling means whether that edge is positive- or negative-going.

9. A circuit as claimed in claim 8, wherein the pulse means comprises:

   delay means for providing a delayed version of the output signal of the sampling means, and Exclusive-OR gate means for combining the output signal of the sampling means with the said delayed version of that signal.

10. A circuit as claimed in claim 9 wherein the delay means comprises a flip-flop having a data input connected to receive the output signal of the sampling means.

11. A circuit comprising:

    a terminal for receiving a data signal
    means for extracting a clock signal from the data signal
    means for generating a local clock signal
    pulse length adjustment means for adjusting the length of pulses of the extracted clock signal to provide a pulse length adjusted extracted clock signal,
    a first sampling means for sampling the pulse length adjusted extracted clock signal at times determined by the local clock signal to provide an output, and
    a second sampling means for sampling the data signal at times determined by the output of the first sampling means.

12. A network switch, or an integrated circuit for use in a network switch, comprising: an aligning circuit as claimed any one of claims 1 to 10 or a circuit as claimed in claim 11.

Fig. 1

Fig. 3

EP 0 942 533 A2

Fig. 2

Fig. 4

EP 0 942 533 A2

23 PHYSICAL INTERFACE (PHY)
26 DATA BUS
25
D D D D — Q Q Q Q
30
29 CLOCK ALIGNER
EXTRACTED CLOCK
27
28 DATA VALID
31
D Q
SWITCH CLOCK
24
ETHERNET LINK (ENCODED CLOCK / DATA)

*Fig. 5*

28 DATA VALID
26 DATA BUS
27 CLOCK
31 SYNCHRONISED CLOCK (SAMPLE CLOCK)
32

*Fig. 6*